# EUROPEAN PATENT APPLICATION

(11) **EP 4 521 856 A1**
(43) Date of publication of application: **12.03.2025**
(21) Application number: 23826257.0
(22) Date of filing: 15.06.2023
(51) Int. Cl.: H05K 1/02

(54) **CIRCUIT BOARD AND TERMINAL**

(30) Priority: 24.06.2022 CN 202210738709
(71) Applicant: Huawei Technologies Co., Ltd., Shenzhen, Guangdong 518129 (CN)
(72) Inventor: ZHOU, Jianjun, Shenzhen, Guangdong 518129 (CN); DI, Wei, Shenzhen, Guangdong 518129 (CN); WANG, Tianpeng, Shenzhen, Guangdong 518129 (CN); SHU, Yufei, Shenzhen, Guangdong 518129 (CN)
(74) Representative: Isarpatent
(86) International application number: PCT/CN2023/100346
(87) International publication number: WO 2023/246608

(57) **Abstract**

This application provides a circuit board, including: a substrate; a routing layer located on a surface of the substrate, where the routing layer is configured to transmit a first electrical signal and a second electrical signal, and a frequency of the first electrical signal is higher than a frequency of the second electrical signal; a ground layer located on a side of the substrate, where the ground layer is configured to provide a reference potential for the second electrical signal; and an anti-interference structure, configured to form a parasitic capacitor to provide a reference potential for the first electrical signal. This application further provides a terminal.

## Description

### CROSS-REFERENCE TO RELATED APPLICATIONS

This application claims priority to Chinese Patent Application No. 202210738709.6, filed with the China National Intellectual Property Administration on June 24, 2022 and entitled "CIRCUIT BOARD AND TERMINAL", which is incorporated herein by reference in its entirety.

### TECHNICAL FIELD

This application relates to the field of power electronics technologies, and in particular, to a circuit board and a terminal in which the circuit board is used.

### BACKGROUND

Terminal products (such as mobile phones and computers) gradually develop toward miniaturization, lightness and thinness, and diversification of functions, which makes requirements for stability and precision of various hardware modules in the terminal products increasingly high.

A camera module in the terminal product is used as an example. The camera module establishes an electrical connection to other functional modules in the terminal product through a plurality of ports of an electrical connector. With increase of a frame rate of the camera module, a working signal in the camera module is a high-frequency signal. However, in the electrical connector, a port for transmitting a high-frequency signal has a high impedance to ground and a weak anti-interference capability, which is likely to cause a problem of a distorted screen of the camera module.

A solution for resolving the problem is to increase a quantity of ground ports of the electrical connector, but this solution increases a volume of the electrical connector. When the electrical connector is used in the terminal product, it is difficult to satisfy requirements for miniaturization and lightness and thinness of the terminal product.

### SUMMARY

A first aspect of this application provides a circuit board, including:
a substrate;
a routing layer located on a surface of the substrate, where the routing layer is configured to transmit a first electrical signal and a second electrical signal, and a frequency of the first electrical signal is higher than a frequency of the second electrical signal;
a ground layer located on a side of the substrate, where the ground layer is configured to provide a reference potential for the second electrical signal; and
an anti-interference structure, configured to form a parasitic capacitor to provide a reference potential for the first electrical signal.

The circuit board includes the routing layer, the routing layer is configured to transmit the first electrical signal and the second electrical signal, the frequency of the first electrical signal is higher than that of the second electrical signal, and the ground layer provides a reference potential for the second electrical signal. When the circuit board is electrically connected to an electrical connector, the routing layer transmits the first electrical signal and the second electrical signal to each signal port of the electrical connector. However, a quantity of ground ports of the electrical connector is limited. As a result, there is a lack of a good potential reference when the first electrical signal whose frequency is higher is transmitted on the electrical connector, causing a large ground impedance of the first electrical signal whose frequency is higher. Consequently, an anti-interference degree is low at a port of the electrical connector configured to transmit the first electrical signal. The foregoing circuit board is provided with the anti-interference structure, and the anti-interference structure forms the parasitic capacitor to provide the reference potential for the first electrical signal. This helps reduce the ground impedance of the first electrical signal, and therefore improves the anti-interference degree at the port of the electrical connector configured to transmit the first electrical signal whose frequency is higher. In this way, the circuit board resolves a problem of a weak anti-interference capability of the electrical connector without changing a structure of the electrical connector, and can avoid increasing a physical size of the electrical connector, so that when the electrical connector is used in a terminal, requirements for miniaturization and lightness and thinness of the terminal are satisfied.

In some embodiments, the anti-interference structure and the ground layer form the parasitic capacitor to provide the reference potential for the first electrical signal.

In some embodiments, the anti-interference structure is located on the surface of the substrate on which the routing layer is formed.

In some embodiments, the anti-interference structure is electrically connected to the routing layer.

In this way, the routing layer and the anti-interference structure may be formed in a same manufacture procedure.

In some embodiments, the anti-interference structure is configured to transmit the second electrical signal with the routing layer.

In some embodiments, the routing layer includes at least one trace for transmitting the second electrical signal, and the anti-interference structure is electrically connected to an end of the trace.

In this way, the anti-interference structure is not used for transmission of the second electrical signal, and there is no need to consider shortening a transmission path of the second electrical signal, so that design of a position and a structure of the anti-interference structure is more flexible.

In some embodiments, the circuit board includes a first substrate and a second substrate, the routing layer is located on a surface of the first substrate, and the anti-interference structure is located on a surface of the second substrate and is electrically connected to the routing layer.

In this way, the routing layer and the anti-interference structure are located at different layers, so that space of the routing layer can be freed, and more traces can be arranged.

In some embodiments, the anti-interference structure forms the parasitic capacitor to provide the reference potential for the first electrical signal.

In some embodiments, the anti-interference structure includes a first anti-interference portion and a second anti-interference portion that are electrically insulated from each other, the first anti-interference portion is electrically connected to the routing layer, the second anti-interference portion is grounded, and the first anti-interference portion and the second anti-interference portion have directly facing areas to form the parasitic capacitor.

In some embodiments, the first anti-interference portion and the second anti-interference portion each include a main portion and a plurality of extension portions extending from a side of the main portion, and the extension portions on the first anti-interference portion and the extension portions on the second anti-interference portion are arranged alternately to form the parasitic capacitor.

In some embodiments, the anti-interference structure and the routing layer form the parasitic capacitor to provide the reference potential for the first electrical signal.

In some embodiments, a buried capacitance layer and a high dielectric layer are further included. The high dielectric layer is located between the buried capacitance layer and the substrate, and the anti-interference structure is buried in the buried capacitance layer.

In some embodiments, the anti-interference portion and the routing layer are made of a same material.

In this way, the routing layer and the anti-interference structure may be formed in a same manufacture procedure.

In some embodiments, the circuit board is a multi-layer printed circuit board.

A second aspect of this application provides a terminal, including:
a first circuit and an electrical connector electrically connected to the first circuit board.

The first circuit board is the circuit board according to any one of the foregoing items.

The terminal includes the first circuit board and the electrical connector that are electrically connected to each other. The first circuit board includes a routing layer, the routing layer is configured to transmit a first electrical signal and a second electrical signal, a frequency of the first electrical signal is higher than that of the second electrical signal, and a ground layer provides a reference potential for the second electrical signal. When the circuit board is electrically connected to the electrical connector, the routing layer transmits the first electrical signal and the second electrical signal to each signal port of the electrical connector. However, a quantity of ground ports of the electrical connector is limited. As a result, there is a lack of a good potential reference when the first electrical signal whose frequency is higher is transmitted on the electrical connector, causing a large ground impedance of the first electrical signal whose frequency is higher. Consequently, an anti-interference degree is low at a port of the electrical connector configured to transmit the first electrical signal. In the terminal, the first circuit board is provided with an anti-interference structure, and the anti-interference structure forms a parasitic capacitor to provide a reference potential for the first electrical signal. This helps reduce the ground impedance of the first electrical signal, and therefore improves the anti-interference degree at the port of the electrical connector configured to transmit the first electrical signal whose frequency is higher. In this way, the terminal resolves a problem of a weak anti-interference capability of the electrical connector without changing a structure of the electrical connector, and can avoid increasing a physical size of the electrical connector, so that the terminal satisfies requirements for miniaturization and lightness and thinness.

A third aspect of this application provides a terminal, including:
a first circuit;
an electrical connector, where the electrical connector is electrically connected to the first circuit board; and
a conductive structure, where the conductive structure is grounded.

The first circuit board includes:
a substrate;
a routing layer located on a surface of the substrate, where the routing layer is configured to transmit a first electrical signal and a second electrical signal, and a frequency of the first electrical signal is higher than a frequency of the second electrical signal;
a ground layer located on a side of the substrate, where the ground layer is configured to provide a reference potential for the second electrical signal; and
an anti-interference structure, where the anti-interference structure and the conductive structure form a parasitic capacitor to provide a reference potential for the first electrical signal.

The terminal includes the first circuit board and the electrical connector that are electrically connected to each other. The first circuit board includes the routing layer, the routing layer is configured to transmit the first electrical signal and the second electrical signal, the frequency of the first electrical signal is higher than that of the second electrical signal, and the ground layer provides a reference potential for the second electrical signal. When the circuit board is electrically connected to the electrical connector, the routing layer transmits the first electrical signal and the second electrical signal to each signal port of the electrical connector. However, a quantity of ground ports of the electrical connector is limited. As a result, there is a lack of a good potential reference when the first electrical signal whose frequency is higher is transmitted on the electrical connector, causing a large ground impedance of the first electrical signal whose frequency is higher. Consequently, an anti-interference degree is low at a port of the electrical connector configured to transmit the first electrical signal. The terminal further includes the grounded conductive structure, and the first circuit board is provided with the anti-interference structure, so that the anti-interference structure and the conductive structure form the parasitic capacitor to provide the reference potential for the first electrical signal. This helps reduce the ground impedance of the first electrical signal, and therefore improves the anti-interference degree at the port of the electrical connector configured to transmit the first electrical signal whose frequency is higher. In this way, the terminal resolves a problem of a weak anti-interference capability of the electrical connector without changing a structure of the electrical connector, and can avoid increasing a physical size of the electrical connector, so that the terminal satisfies requirements for miniaturization and lightness and thinness.

### BRIEF DESCRIPTION OF DRAWINGS

FIG. 1 is a diagram of a three-dimensional structure of a terminal in Embodiment 1 of this application;
FIG. 2 is a diagram of a module structure of a terminal in Embodiment 1 of this application;
FIG. 3 is a diagram of distribution of signal ports of an electrical connector in a terminal in Embodiment 1 of this application;
FIG. 4 is a diagram of a structure of a first circuit board in a terminal in Embodiment 1 of this application;
FIG. 5 is a diagram of a connection relationship between a first circuit board and a second circuit board that are not provided with an anti-interference structure and an electrical connector;
FIG. 6 is a diagram of a connection relationship between a first circuit board, a second circuit board, and an electrical connector in Embodiment 1 of this application;
FIG. 7 shows a circuit structure of a first circuit board, a second circuit board, and an electrical connector during transmission of a low-frequency signal in Embodiment 1 of this application;
FIG. 8 shows a circuit structure of a first circuit board, a second circuit board, and an electrical connector during transmission of a high-frequency signal in Embodiment 1 of this application;
FIG. 9 is a diagram of impedance change curves over time of terminals in a comparative example and Embodiment 1 of this application;
FIG. 10 is a diagram of a structure of a first circuit board in a terminal in Embodiment 2 of this application;
FIG. 11 is a diagram of a structure of a first circuit board in a terminal in Embodiment 3 of this application;
FIG. 12 is a diagram of a structure of a first circuit board in a terminal in Embodiment 4 of this application; and
FIG. 13 is a diagram of a structure of a first circuit board in a terminal in Embodiment 5 of this application.

### DESCRIPTION OF EMBODIMENTS

The following describes embodiments of this application with reference to accompanying drawings in embodiments of this application.

### Embodiment 1

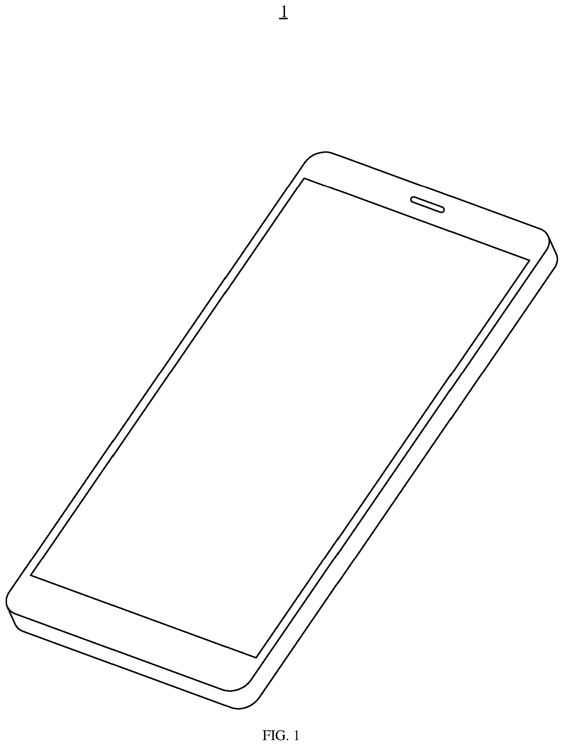

A terminal 1 in this embodiment is shown in FIG. 1. The terminal 1 may be a smartphone, a tablet computer, a television, a display, a vehicle-mounted device, or the like. In this embodiment, an example in which the terminal 1 is a smartphone is used for description.

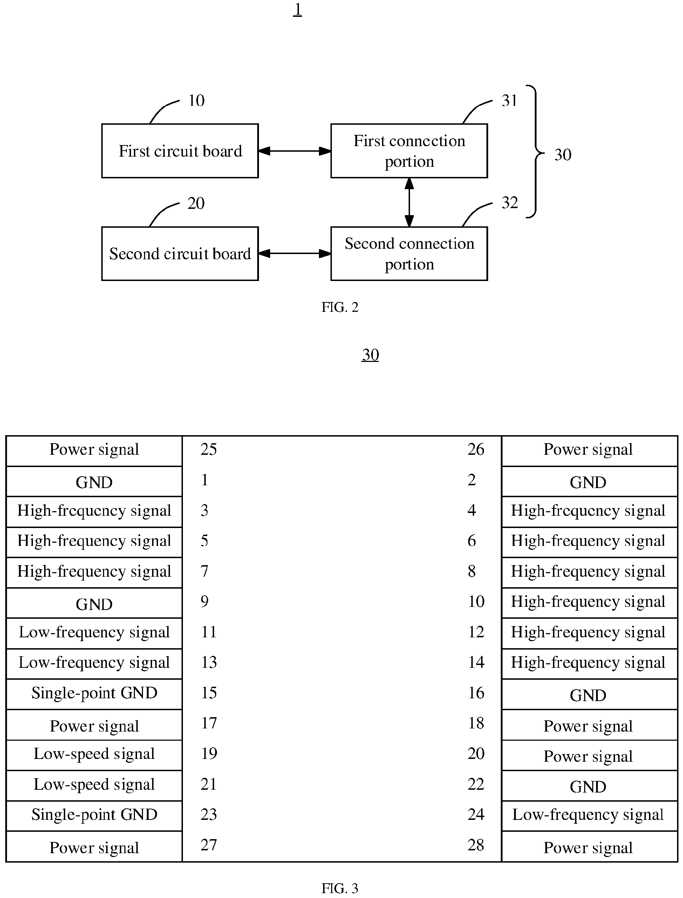

Refer to FIG. 2. The terminal 1 includes a first circuit board 10, a second circuit board 20, and an electrical connector 30. The electrical connector 30 includes a first connection portion 31 and a second connection portion 32. The first connection portion 31 is electrically connected to the first circuit board 10, the second connection portion 32 is electrically connected to the second circuit board 20, and the first connection portion 31 and the second connection portion 32 are snapped (or plugged) to each other to establish an electrical connection between the first circuit board 10 and the second circuit board 20, so that an electrical signal can be transmitted between the first circuit board 10 and the second circuit board 20.

In this embodiment, the first circuit board 10 is a primary board of the terminal 1, the second circuit board 20 is a secondary board of a functional module (for example, a camera module) in the terminal 1, the first connection portion 31 is a female connector of the electrical connector 30, and the second connection portion 32 is a male connector of the electrical connector 30. In another embodiment, the first circuit board 10 may be a secondary board, the second circuit board 20 may be a primary board, the first connection portion 31 may be a male connector, and the second connection portion 32 may be a female connector.

In this embodiment, the first connection portion 31 is fastened to the first circuit board 10 through soldering. A plurality of pads (not shown in the figure) are reserved at a transmission port (not shown in the figure) on the first circuit board 10, so that signal ports on the first connection portion 31 of the electrical connector 30 are soldered to the pads in a one-to-one correspondence. Similarly, the second connection portion 32 is fastened to the second circuit board 20 through soldering. A plurality of pads (not shown in the figure) are reserved at a transmission port (not shown in the figure) on the second circuit board 20, so that signal ports on the second connection portion 32 of the electrical connector 30 are soldered to the pads in a one-to-one correspondence. A manner of fastening the electrical connector 30 to the first circuit board 10 and the second circuit board 20 is not limited in this application.

In this embodiment, the electrical connector 30 includes a plurality of signal ports. FIG. 3 is a diagram of distribution of signal ports (numbered 1 to 28) of the electrical connector 30 in this embodiment. It can be learned from FIG. 3 that the electrical connector 30 in this embodiment includes a plurality of types of signal ports, and different types of signal ports transmit different types of signals. For example, the signal ports 25 to 28 are configured to transmit a power signal, the signal ports 3 to 8, 10, 12, and 14 are configured to transmit a high-frequency signal, the signal ports 11, 13, 19, 21, and 24 are configured to transmit a low-frequency signal, and the signal ports 1, 2, 9, 15, 16, 22, and 23 are configured to connect to a reference ground.

In this embodiment, a low-frequency signal is defined as a signal whose frequency is less than or equal to 10 MHz, for example, a reset signal or a detection signal; and a high-frequency signal is defined as a signal whose frequency is greater than 10 MHz, for example, a mobile industry processor interface (Mobile Industry Processor Interface, MIPI) data signal or a clock signal.

It can be learned from FIG. 3 that in the electrical connector 30, a quantity of signal ports connected to a reference ground is limited, and for a high-frequency signal, there is a lack of a good signal reference, an impedance to ground is large, and an anti-interference capability is weak. Consequently, radio frequency signal interference is likely to occur at a signal port of the electrical connector 30 configured to transmit a high-frequency signal. In other words, an anti-interference capability is weak at the signal port of the electrical connector 30 configured to transmit the high-frequency signal. The radio frequency signal interference is likely to affect the second circuit board 20 electrically connected to the electrical connector 30, further affecting function implementation of a functional module connected to the second circuit board 20 (for example, causing a problem of a distorted screen of the camera module). In this embodiment, an anti-interference structure is disposed in the first circuit board 10 and/or the second circuit board 20, to resolve a problem of a weak anti-interference capability of the electrical connector 30 without changing a structure of the electrical connector 30, and avoid increasing a physical size of the electrical connector 30, so that when the electrical connector 30 is used in the terminal 1, requirements for miniaturization and lightness and thinness of the terminal 1 are satisfied.

In this embodiment, anti-interference structures in the first circuit board 10 and the second circuit board 20 are similar. The following uses the anti-interference structure in the first circuit board 10 as an example for description.

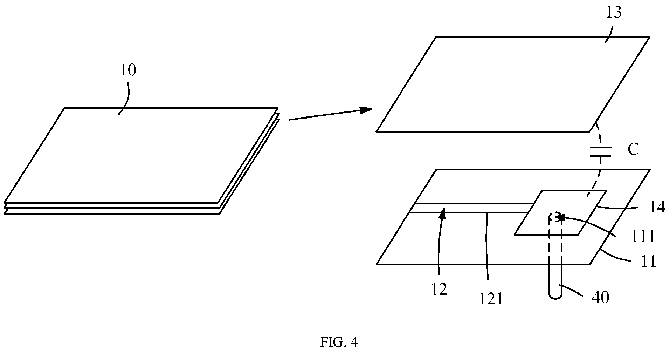

Refer to FIG. 4. In this embodiment, the first circuit board 10 includes a substrate 11, a routing layer 12, and a ground layer 13. The substrate 11 is configured to carry the routing layer 12. The routing layer 12 is located on a surface of the substrate 11. The ground layer 13 is located on a side that is of the substrate 11 and on which the routing layer 12 is disposed. In other words, the routing layer 12 is located between the substrate 11 and the ground layer 13.

In this embodiment, the first circuit board 10 is a printed circuit board, and the substrate 11 is a sheet-like insulating material. A conductive pattern is formed at the routing layer 12, the conductive pattern includes a plurality of traces (FIG. 4 shows only one trace 121), and each trace is configured to transmit an electrical signal. Some of the traces are configured to transmit a first electrical signal, and some of the traces are configured to transmit a second electrical signal. In this embodiment, the first electrical signal includes a high-frequency signal, and the second electrical signal includes a low-frequency signal. For example, the trace 121 shown in FIG. 4 is configured to transmit the second electrical signal, that is, configured to transmit a power signal or a low-frequency signal. The ground layer 13 is a sheet-like conductive structure having substantially the same potential at each place, and is configured to provide a reference potential (namely, a reference ground) for the second electrical signal transmitted by the routing layer 12.

The first circuit board 10 further includes an anti-interference structure 14, and the anti-interference structure is configured to provide a reference potential (namely, a reference ground) for the first electrical signal. In this embodiment, the anti-interference structure 14 is located on the surface of the substrate 11 on which the routing layer 12 is formed. In other words, in this embodiment, the anti-interference structure 14 and the routing layer 12 are disposed at a same layer. In this embodiment, the anti-interference structure 14 is a sheet-like rectangular conductive block with a continuous pattern. In other words, an orthographic projection of the anti-interference structure 14 onto the substrate 11 is a rectangle. In this embodiment, the anti-interference structure 14 is electrically connected to the trace 121, and the trace 121 and the anti-interference structure 14 jointly serve as a transmission path for transmitting a power signal or a low-frequency signal. In other words, the power signal or the low-frequency signal passes through the trace 121 and the anti-interference structure 14. In this embodiment, both the anti-interference structure 14 and the routing layer 12 are metal and made of a same material, so as to be formed in a same etching procedure. In this embodiment, the anti-interference structure 14 and the ground layer 13 have directly facing areas. In other words, an orthographic projection of the anti-interference structure 14 onto a plane on which the ground layer 13 is located overlaps the ground layer 13, so that the anti-interference structure 14 and the ground layer 13 can form a parasitic capacitor C.

In this embodiment, each trace in the routing layer 12 is connected to a signal transmission port of the first circuit board 10 directly or through a connection line 40, so as to be electrically connected to a corresponding pad at the transmission port, and an electrical signal is transmitted to the second circuit board 20 through the electrical connector 30 soldered to the pad. In this embodiment, the substrate 11 is provided with a through hole 111, the anti-interference structure 14 covers the through hole 111, and one end of the connection line 40 is in electrical contact with the anti-interference structure 14, and extends along the through hole 111 to the signal transmission port of the first circuit board 10.

In this embodiment, the trace 121 is a trace adjacent to a trace for transmitting a high-frequency signal. In another embodiment, the routing layer 12 includes a plurality of traces configured to transmit a power signal or a low-frequency signal, and one anti-interference structure 14 is disposed at each trace for transmitting a power signal or a low-frequency signal, so that each anti-interference structure 14 forms a parasitic capacitor C with the ground layer 13.

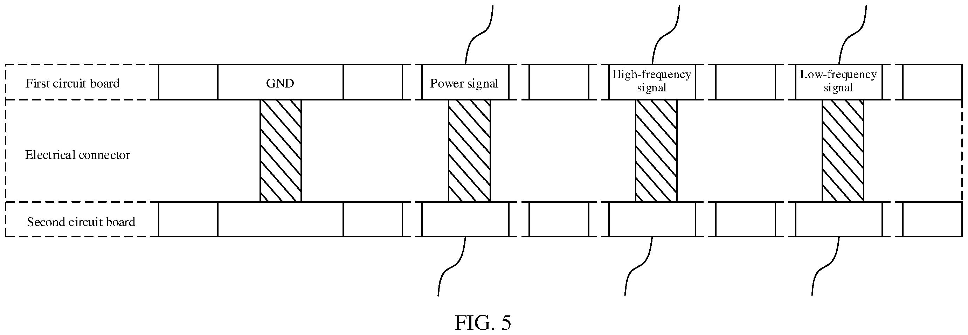

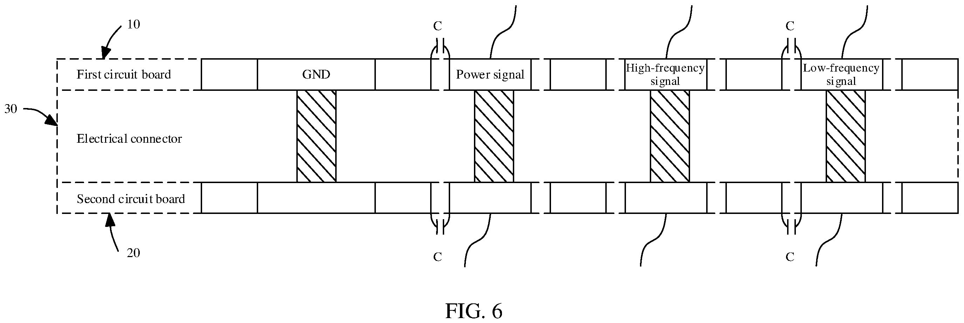

For a connection relationship between a first circuit board and a second circuit board that are not provided with an anti-interference structure 14 and an electrical connector, refer to FIG. 5. For a connection relationship between the first circuit board 10, the second circuit board 20, and the electrical connector 30 in this embodiment, refer to FIG. 6. A main difference between the connection relationships shown in FIG. 6 and FIG. 5 lies in that, in this embodiment, an anti-interference structure 14 is disposed at a trace for transmitting a power signal and a low-frequency signal in the first circuit board 10 and the second circuit board 20, to form a parasitic capacitor C.

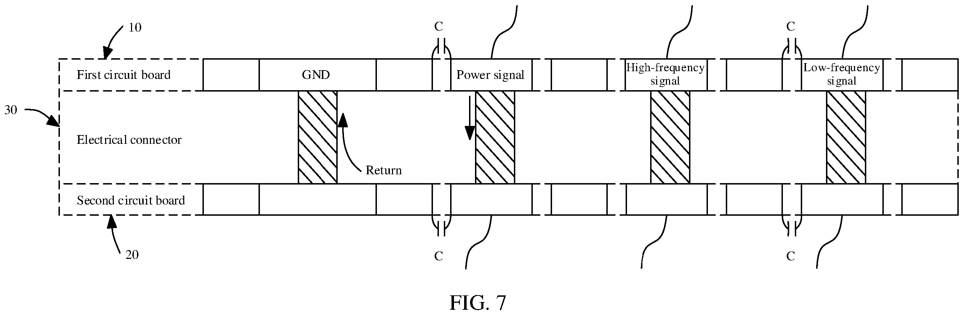

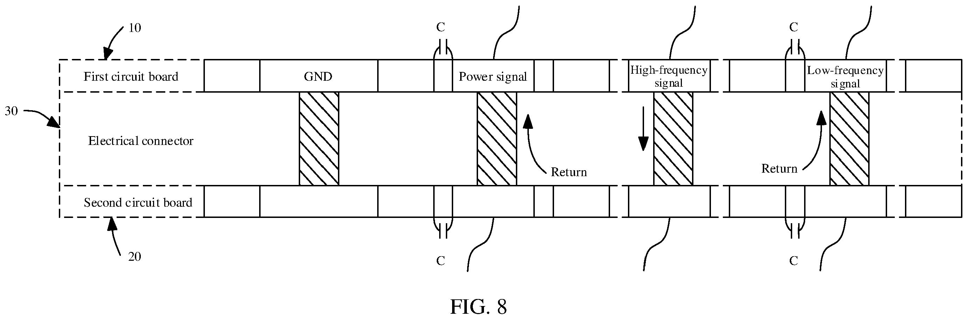

Refer to FIG. 7. For a low-frequency signal, a state of the parasitic capacitor C is equivalent to an open circuit, so that circuit structures of the first circuit board 10 and the second circuit board 20 obtained when the anti-interference structure 14 is disposed are substantially the same as those obtained when the anti-interference structure 14 is not disposed. In this case, a transmission path of the low-frequency signal is not affected. Refer to FIG. 8. For a high-frequency signal, a state of the parasitic capacitor C is equivalent to a short circuit. In this case, the anti-interference structure 14 is grounded, and the high-frequency signal may use a nearest anti-interference structure 14 as a reference ground, without a need to refer to a reference ground that is far away. This helps reduce a ground impedance of the high-frequency signal, and therefore helps improve an anti-interference degree at a signal port of the electrical connector 30 for transmitting a high-frequency signal (that is, at a signal transmission port connected to a trace for transmitting a high-frequency signal in the first circuit board 10 and the second circuit board 20).

Improvement effect of the anti-interference structure 14 in this embodiment on an anti-interference degree is verified below through experiment.

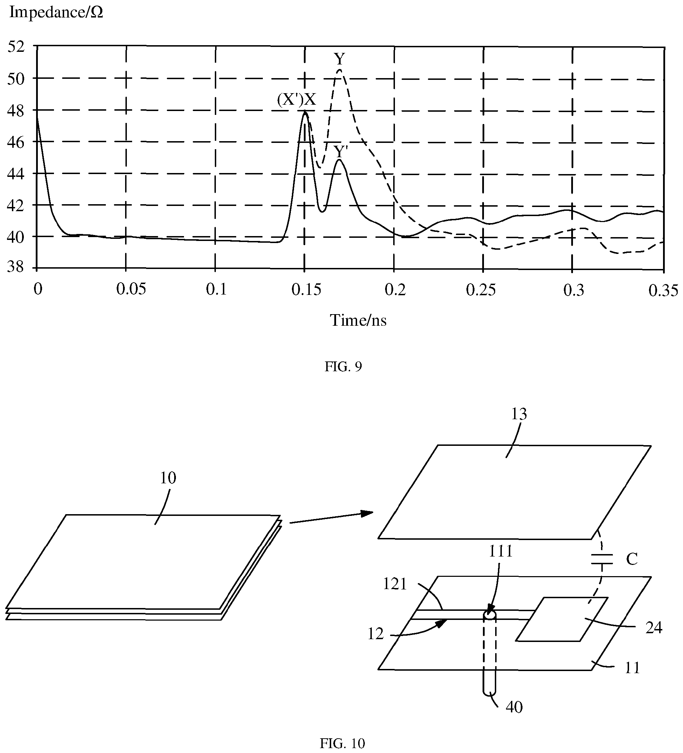

In FIG. 9, a horizontal coordinate indicates time, a vertical coordinate indicates an impedance, a dashed line indicates an impedance change curve over time in a comparative example, and a solid line indicates an impedance change curve over time in this embodiment. It can be learned from FIG. 9 that, in the comparative example, the impedance has two sharp changes: X and Y; and in this embodiment, the impedance also has two sharp changes: X' and Y'. The impedance is suddenly increased at X, Y, X', and Y', indicating that an anti-interference degree is decreased at time corresponding to X, Y, X', and Y'. Because the time indicated by the horizontal coordinate is in direct proportion to a transmission period of an electrical signal, the horizontal coordinate may further reflect a transmission distance of the electrical signal. In this case, a position at which a sharp impedance change occurs may be deduced based on a value of the horizontal coordinate, to determine a position at which the impedance is large and the anti-interference degree is low in the terminal. According to calculation, in both the comparative example and this embodiment, a position at which a sharp impedance increase occurs is a signal port of the connector for transmitting a high-frequency signal. It can be clearly learned from FIG. 9 that, the impedance at the signal port of the connector for transmitting the high-frequency signal in this embodiment is lower than the impedance at the signal port of the connector for transmitting the high-frequency signal in the comparative example. In this case, the anti-interference degree at the signal port of the connector for transmitting the high-frequency signal in this embodiment is higher than the anti-interference degree at the signal port of the connector for transmitting the high-frequency signal in the comparative example. Therefore, the terminal 1, the first circuit board 10, and the second circuit board 20 in this embodiment help improve an anti-interference degree at a signal port of the electrical connector 30 configured to transmit a high-frequency signal.

In this embodiment, the first circuit board 10 is a multi-layer printed circuit board. Compared with the structure shown in FIG. 4, the first circuit board 10 in this embodiment may further include more substrates 11, routing layers 12, and ground layers 13. A structure relationship between the substrate 11, the routing layer 12, and the ground layer 13 in FIG. 4 is merely an example. When the first circuit board 10 includes a plurality of substrates 11, routing layers 12, and ground layers 13, one substrate 11 is disposed between adjacent routing layers 12 and between a routing layer 12 and a ground layer 13 that are adjacent to each other. The substrate 11 is provided with a through hole, so that an electrical connection is established between the routing layers 12 or between the routing layer 12 and the ground layer 13 on two sides of the substrate 11 through the through hole. When the first circuit board 10 includes a plurality of substrates 11, an anti-interference structure 14 may be disposed on a surface of each substrate 11, or an anti-interference structure 14 may be disposed on a surface of some of the substrates 11. In this embodiment, each anti-interference structure 14 and a ground layer 13 closest to the anti-interference structure 14 form a parasitic capacitor.

In another embodiment of this application, the first circuit board 10 may alternatively be a single-layer printed circuit board or a double-layer printed circuit board.

In this embodiment, the electrical connector 30 is a board-to-board (Board to aboard, BTB) connector. In another embodiment, the electrical connector 30 may alternatively be a zero insertion force (Zero Insertion Force, ZIF) connector, a Type-C connector, or the like.

According to the terminal 1, the first circuit board 10, and the second circuit board 20 in this embodiment, an anti-interference structure 14 is disposed at a signal transmission port connected to a trace for transmitting a power signal and/or a low-frequency signal, so that the anti-interference structure 14 and the ground layer 13 form a parasitic capacitor C. For a high-frequency signal, a state of the parasitic capacitor C is equivalent to a short circuit. In this case, the anti-interference structure 14 is grounded, and may be used as a reference ground of the high-frequency signal. The anti-interference structure 14 is located at a transmission port connected to a trace adjacent to a trace for transmitting a high-frequency signal. This helps reduce a ground impedance of the high-frequency signal, and improve an anti-interference degree at a signal port of the electrical connector 30 configured to transmit a high-speed signal.

### Embodiment 2

A main difference between a terminal provided in this embodiment and the terminal 1 in Embodiment 1 lies in that an anti-interference structure is located at a different position.

Refer to FIG. 10. A shape and a structure of an anti-interference structure 24 in this embodiment are substantially the same as those of the anti-interference structure 14 in Embodiment 1, and a main difference lies in that the anti-interference structure 24 in this embodiment is electrically connected to an end of a trace 121. In this embodiment, one end of a connection line 40 is electrically connected to the trace 121 directly, and extends along a through hole 111 to a signal transmission port of a first circuit board 10. A power signal or a low-frequency signal is transmitted to the transmission port through the trace 121 and the connection line 40, so as to be transmitted to an electrical connector 30, and the power signal or the low-frequency signal does not pass through the anti-interference structure 14. The anti-interference structure 14 and a ground layer 13 have directly facing areas, and may form a parasitic capacitor with each other.

Generally, layout design of a trace configured to transmit an electrical signal needs to satisfy a requirement of a shortest path. In this embodiment, because the power signal or the low-frequency signal (namely, an electrical signal) is not transmitted through the anti-interference structure 24, a freedom degree of design of a position and a shape of the anti-interference structure 24 is high.

Therefore, this embodiment can implement all beneficial effects described in Embodiment 1. On this basis, this embodiment further helps improve the freedom degree of the design of the position and the shape of the anti-interference structure 24.

### Embodiment 3

A main difference between a terminal provided in this embodiment and the terminal in Embodiment 1 and Embodiment 2 lies in that an anti-interference structure is located at a different position.

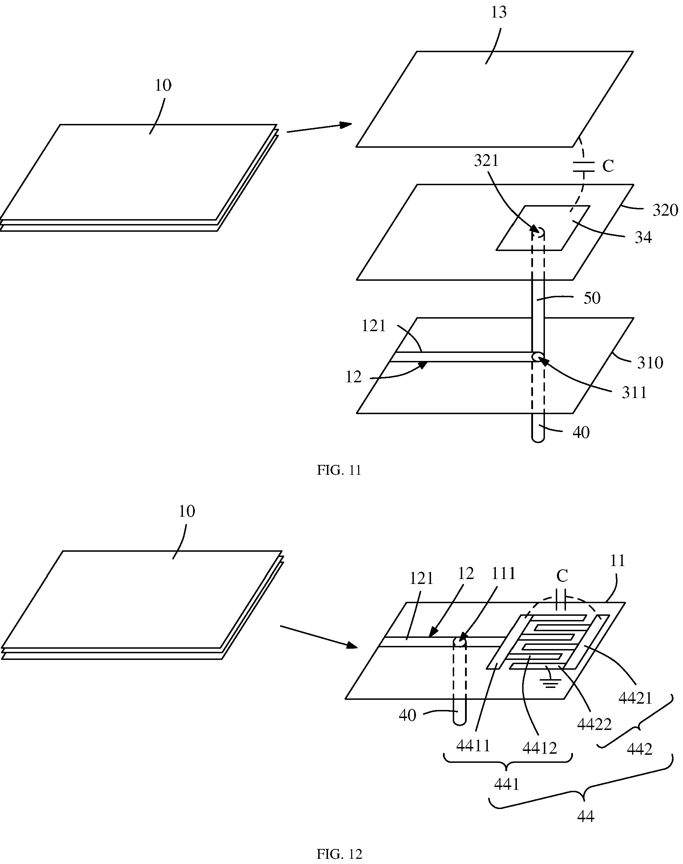

Refer to FIG. 11. In this embodiment, a first circuit board 10 includes a first substrate 310 and a second substrate 320 that are stacked. The second substrate 320 is located between the first substrate 310 and a ground layer 13. A routing layer 12 is located on a surface of the first substrate 310 close to the second substrate 320, and an anti-interference structure 34 is located on a surface of the second substrate 320 away from the first substrate 310. In other words, in this embodiment, the anti-interference structure 34 and the routing layer 12 are located on surfaces of different substrates. In other words, in this embodiment, the anti-interference structure 34 and the routing layer 12 are disposed at different layers.

In this embodiment, the first substrate 310 is provided with a first through hole 311, so that a trace 121 on the first substrate 310 can be electrically connected to the anti-interference structure 34 on the second substrate 320 through a connection line 50 and the through hole 311. The second substrate 320 is provided with a second through hole 321, so that the trace 121 can be electrically connected to a signal transmission port of the first circuit board 10 through the second through hole 321 and a connection line 40. In this embodiment, a power signal and a low-frequency signal are transmitted to the transmission port through the trace 121 and the connection line 40, and the anti-interference structure 34 is not used for transmission of the power signal or the low-frequency signal.

This embodiment can implement all beneficial effects described in Embodiment 1 and Embodiment 2. On this basis, in this embodiment, the anti-interference structure 34 and the routing layer 12 are disposed on surfaces of different substrates, and this helps free an area of the routing layer 12, so that more traces can be arranged at the routing layer 12.

### Embodiment 4

A main difference between a terminal provided in this embodiment and the terminal in Embodiment 1 to Embodiment 3 lies in a position and a structure of an anti-interference structure.

Refer to FIG. 12. In this embodiment, an anti-interference structure 44 is located on a surface of a substrate 11 on which a routing layer 12 is formed, and is electrically connected to a trace 121. The anti-interference structure 44 includes a first anti-interference portion 441 and a second anti-interference portion 442. The first anti-interference portion 441 is electrically connected to the trace 121, and the second anti-interference portion 442 is grounded. The first anti-interference portion 441 and the second anti-interference portion 442 are electrically insulated from each other. In this embodiment, the first anti-interference portion 441 and the second anti-interference portion 442 are comb-like. In other words, the first anti-interference portion 441 includes a main portion 4411 and a plurality of strip-like extension portions 4412 that extend from a side of the main portion and that are arranged in parallel. Similarly, the second anti-interference portion 442 includes a main portion 4421 and a plurality of strip-like extension portions 4422 that extend from a side of the main portion 4421 and that are arranged in parallel. The plurality of extension portions 4412 and the plurality of extension portions 4422 are arranged alternately at intervals. In other words, there is one extension portion 4422 between two adjacent extension portions 4412, and one extension portion 4412 between two adjacent extension portions 4422, so that the first anti-interference portion 441 and the second anti-interference portion 442 have directly facing areas to form a parasitic capacitor C.

The anti-interference structure 44 in this embodiment may also be located at the position of the anti-interference structure in Embodiment 2 and Embodiment 3. In other words, in this embodiment, the anti-interference structure 44 may be configured to transmit a power signal or a low-frequency signal with the trace 121 as described in Embodiment 1; or the anti-interference structure 44 may be connected to an end of the trace 121 as described in Embodiment 2, and does not participate in transmission of a power signal or a low-frequency signal; or the anti-interference structure 44 and the routing layer 12 may be located on surfaces of different substrates as described in Embodiment 3.

This embodiment can implement all beneficial effects described in Embodiment 1 to Embodiment 3.

### Embodiment 5

A main difference between a terminal in this embodiment and the terminal in Embodiment 1 to Embodiment 4 lies in a position and a structure of an anti-interference structure.

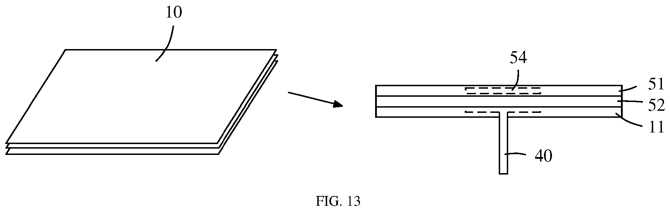

In this embodiment, an anti-interference structure 54 is formed in a first circuit board 10 by using a buried capacitance technology. Refer to FIG. 13. In this embodiment, the first circuit board 10 includes a substrate 11, a routing layer 12, a buried capacitance layer 51, and a high dielectric layer 52. The buried capacitance layer 51 is located on a side that is of the substrate 11 and on which the routing layer 12 is formed, and the high dielectric layer 52 is located between the buried capacitance layer 51 and the routing layer 12. The anti-interference structure 54 is buried in the buried capacitance layer 51. Projections of the anti-interference structure 54 and a trace 121 for transmitting a power signal or a low-frequency signal onto the substrate 11 overlap. In other words, the anti-interference structure 54 and the trace 121 have directly facing areas. In this case, the anti-interference structure 54 and the trace 121 may form a parasitic capacitor. In this embodiment, the anti-interference structure 54 and the trace 21 are also located at different layers.

Therefore, this embodiment can implement all beneficial effects described in Embodiment 1 and Embodiment 3.

In another embodiment of this application, an anti-interference structure may alternatively form a parasitic capacitor with a grounded conductive structure in a terminal other than a first circuit board 10 and a second circuit board 20.

For example, in some embodiments, the electrical connector 30 is fastened by using a support (not shown in the figure). In this embodiment, the support may be a conductive material and disposed to be grounded, and the anti-interference structure 14, 24, or 34 and the support may have directly facing areas, so that the anti-interference structure 14, 24, or 34 and the support can form a parasitic capacitor.

For example, in some other embodiments, a conductive structure (for example, a stainless steel metal plate) may be fastened on a side of the first circuit board 10 and/or the second circuit board 20 by using a conductive adhesive, and the conductive structure is disposed to be grounded, so that the conductive structure and the anti-interference structure 14 form a parasitic capacitor C.

The foregoing other embodiments can also implement all beneficial effects described in Embodiment 1 to Embodiment 3.

A person of ordinary skill in the art should be aware that the foregoing implementations are merely used to describe the present invention, but are not intended to limit the present invention. Appropriate modifications and variations made to the foregoing embodiments shall fall within the protection scope of the present invention provided that the modifications and variations fall within the substantive scope of the present invention.

## Claims

1. A circuit board, comprising:
a substrate;
a routing layer located on a surface of the substrate, wherein the routing layer is configured to transmit a first electrical signal and a second electrical signal, and a frequency of the first electrical signal is higher than a frequency of the second electrical signal;
a ground layer located on a side of the substrate, wherein the ground layer is configured to provide a reference potential for the second electrical signal; and
an anti-interference structure, configured to form a parasitic capacitor to provide a reference potential for the first electrical signal.

2. The circuit board according to claim 1, wherein the anti-interference structure and the ground layer form the parasitic capacitor to provide the reference potential for the first electrical signal.

3. The circuit board according to claim 2, wherein the anti-interference structure is located on the surface of the substrate on which the routing layer is formed.

4. The circuit board according to claim 3, wherein the anti-interference structure is electrically connected to the routing layer.

5. The circuit board according to claim 4, wherein the anti-interference structure is configured to transmit the second electrical signal with the routing layer.

6. The circuit board according to claim 4, wherein the routing layer comprises at least one trace for transmitting the second electrical signal, and the anti-interference structure is electrically connected to an end of the trace.

7. The circuit board according to claim 2, wherein the circuit board comprises a first substrate and a second substrate, the routing layer is located on a surface of the first substrate, and the anti-interference structure is located on a surface of the second substrate and is electrically connected to the routing layer.

8. The circuit board according to claim 1, wherein the anti-interference structure forms the parasitic capacitor to provide the reference potential for the first electrical signal.

9. The circuit board according to claim 8, wherein the anti-interference structure comprises a first anti-interference portion and a second anti-interference portion that are electrically insulated from each other, the first anti-interference portion is electrically connected to the routing layer, the second anti-interference portion is grounded, and the first anti-interference portion and the second anti-interference portion have directly facing areas to form the parasitic capacitor.

10. The circuit board according to claim 9, wherein the first anti-interference portion and the second anti-interference portion each comprise a main portion and a plurality of extension portions extending from a side of the main portion, and the extension portions on the first anti-interference portion and the extension portions on the second anti-interference portion are arranged alternately to form the parasitic capacitor.

11. The circuit board according to claim 1, wherein the anti-interference structure and the routing layer jointly form the parasitic capacitor to provide the reference potential for the first electrical signal.

12. The circuit board according to claim 11, further comprising a buried capacitance layer and a high dielectric layer, wherein the high dielectric layer is located between the buried capacitance layer and the substrate, and the anti-interference structure is buried in the buried capacitance layer.

13. The circuit board according to any one of claims 1 to 6, wherein the anti-interference portion and the routing layer are made of a same material.

14. The circuit board according to any one of claims 1 to 13, wherein the circuit board is a multi-layer printed circuit board.

15. A terminal, comprising:
a first circuit board and an electrical connector electrically connected to the first circuit board, wherein
the first circuit board is the circuit board according to any one of claims 1 to 14.

16. A terminal, comprising:
a first circuit;
an electrical connector electrically connected to the first circuit board; and
a conductive structure, wherein the conductive structure is grounded, wherein
the first circuit board comprises:
a substrate;
a routing layer located on a surface of the substrate, wherein the routing layer is configured to transmit a first electrical signal and a second electrical signal, and a frequency of the first electrical signal is higher than a frequency of the second electrical signal;
a ground layer located on a side of the substrate, wherein the ground layer is configured to provide a reference potential for the second electrical signal; and
an anti-interference structure, wherein the anti-interference structure and the conductive structure jointly form a parasitic capacitor to provide a reference potential for the first electrical signal.
